# EUROPÄISCHE PATENTSCHRIFT

(11) **EP 1 574 777 B1**
(45) Veröffentlichungstag und Bekanntmachung des Hinweises auf die Patenterteilung: **29.02.2012**
(21) Anmeldenummer: 04024133.3
(22) Anmeldetag: 09.10.2004
(51) Int. Cl.: G01R 33/38, F17C 13/00, F25B 9/02, F25B 9/14, F25D 19/00

(54) **Kryostat für ein supraleitendes Magnetsystem**
Cryostat for a superconducting magnet system
Cryostat pour un système magnétique supraconducteur

(30) Priorität: 13.03.2004 DE 102004012416
(43) Veröffentlichungstag der Anmeldung: 14.09.2005
(73) Patentinhaber: Bruker BioSpin GmbH, 76287 Rheinstetten (DE)
(72) Erfinder: Roth, Gerhard, Dr., 76287 Rheinstetten (DE)
(74) Vertreter: Kohler Schmid Möbus

(56) Entgegenhaltungen:
- DE-A1- 10 226 498
- JP-A- 2002 124 410
- US-A- 5 220 800
- US-A- 5 381 666
- DATABASE WPI Week 198611 Thomson Scientific, London, GB; AN 1986-072341 XP002606619, -& JP 61 022158 A (TOSHIBA KK) 30. Januar 1986 (1986-01-30)

## Beschreibung

Die Erfindung betrifft einen Kryostaten mit einem ersten Helium-Tank, der Helium mit einer Betriebstemperatur T1 < 3K enthält und einen zweiten Helium-Tank, der mit dem ersten Helium-Tank in Verbindung steht und flüssiges Helium bei einer Betriebstemperatur T₂ > 3K enthält, wobei im ersten Helium-Tank eine Kühleinrichtung vorgesehen ist, die im ersten Helium-Tank eine Betriebstemperatur T₁<3K erzeugt, und wobei die Kühleinrichtung als Joule-Thomson-Ventil mit nachgeschaltetem Wärmetauscher ausgeführt ist, aus welchem abgepumptes Helium in einen Raumtemperaturbereich außerhalb des Kryostaten gefördert wird. Ein solches Magnetsystem ist aus der US 5,220,800 an sich bekannt.

Derartige supraleitende Magnetsysteme umfassen im Allgemeinen einen Kryostaten mit zwei Kammern, wobei in der ersten Kammer eine supraleitende Magnetspule angeordnet ist und die zweite Kammer als Helium-Vorrat dient, welcher sich unter Atmosphärendruck oder leichtem Überdruck auf einer Temperatur von ca. 4,2K befindet. Die beiden Kammern kommunizieren miteinander, so dass Helium von der oberen in die untere Kammer strömen kann, wo es mit Hilfe einer in die erste Kammer ragenden Unterkühleinheit auf eine Temperatur deutlich unter 4,2K abgekühlt wird. Ein Strahlungsschild reduziert die einfallende Strahlungsenergie und enthält einen mit einer kryogenen Flüssigkeit gefüllten Tank, der den Strahlungsschild kühlt.

Zur Unterkühlung des Heliums in der ersten Kammer sind Unterkühleinheiten bekannt, bei denen das Helium durch ein Nadelventil auf niedrigen Druck entspannt und aus der ersten Kammer abgepumpt wird. Nachteilig daran ist, dass das abgepumpte Helium dem System entzogen wird, so dass sich die zweite Kammer, die mit der ersten in Verbindung steht, langsam entleert, so dass in regelmäßigen Abständen das Helium in der zweiten Kammer wieder ersetzt werden muss.

Zur Kühlung des Heliums in Kryostaten mit einer Kammer oder auch zur Kühlung von Strahlungsschildern sind Refrigeratoren bekannt, bei denen die Expansion beziehungsweise Kompression eines Arbeitsgases mittels einer Kolbenbewegung erfolgt (Kolbenrefrigerator). Nachteilig daran ist die ständige Kolbenbewegung, die einerseits Erschütterungen erzeugt und zum anderen aufgrund des metallischen Kolbens magnetische Störungen im Hauptmagnetfeld der Spule verursacht. Zudem macht die Bewegung des Kolbens am kalten Ende des Refrigerators Probleme, da eine Schmierung aufgrund der niedrigen Temperatur nicht möglich ist, was zu kurzen Wartungsintervallen führt.

Pulsrohr-Kühler dagegen realisieren die Expansion beziehungsweise die Kompression des Arbeitsgases mit Hilfe einer Stoßwellenfront in einem Pulsrohr. Die Stoßwellenfront wird hierbei von einer geeigneten Ventilanordnung, üblicherweise von einem rotierenden Ventil, gesteuert. Das Pulsrohr ist mit einem Regenerator verbunden, in dem ein Wärmeaustausch zwischen dem Arbeitsgas und dem Regeneratormaterial stattfindet. Nach einer Verdichtung des Arbeitsgases durchströmt das Gas den Regenerator, um dann im Expansionsraum einer Entspannung unterzogen zu werden. Das sich dabei abkühlende Gas nimmt Wärme aus der Umgebung des Expansionsraums auf, was zu einer Kühlung der Umgebung führt. Da das rotierende Ventil nicht in unmittelbarer Nähe des Magnetsystems angebracht sein muss, stellt ein Pulsrohr-Kühler eine laufruhige, verschleißarme Kühleinrichtung dar, die auf bewegliche Teile im Bereich tiefer Temperaturen verzichtet.

Bei dem Magnetsystem nach der US 5,220,800 pumpt die in die erste Kammer ragende Unterkühleinheit flüssiges Helium ab, welches durch Expansion eine Unterkühlung des Heliumbades in der ersten Kammer bewirkt. Nachteilig an dieser Anordnung ist, dass durch den Refrigerator ständig Helium verbraucht wird. Dies ist insbesondere störend, da zum Nachfüllen des Heliums der Messbetrieb unterbrochen werden muss und somit mit einem erheblichen Aufwand verbunden ist. Zudem ist Helium nicht überall in beliebigen Mengen verfügbar. Es ist daher wünschenswert, den Heliumverbrauch einer derartigen Magnetanordnung zu reduzieren.

Aufgabe der Erfindung ist es daher, ein supraleitendes Magnetsystem vorzuschlagen, bei dem der Heliumverbrauch minimiert wird und somit der Messbetrieb durch häufiges Helium Nachfüllen nicht unnötig unterbrochen werden muss.

Diese Aufgabe wird erfindungsgemäß dadurch gelöst, dass ein Refrigerator vorgesehen ist, dessen kaltes Ende in den zweiten Helium-Tank ragt, und dass im Normalbetrieb das geförderte Helium in einem geschlossenen Kreislauf entlang des Refrigerators in den zweiten Helium-Tank zurückgeführt, dadurch vorgekühlt und am kalten Ende des Refrigerators verflüssigt wird.

Wie bei der bekannten Einrichtung kann flüssiges Helium über eine Kühleinrichtung im ersten Tank abgepumpt werden. Durch die Expansion des Heliums mittels eines Joule-Thomson-Ventils und eines Wärmeaustauschs im nachgeschalteten Wärmetauscher wird eine Unterkühlung des Heliums im ersten Tank erzeugt. Im Gegensatz zu bekannten Anordnungen strömt das expandierte Helium bei dem erfindungsgemäßen Magnetsystem jedoch nicht nach außen ab, sondern kann in einem geschlossenen Kreislauf dem zweiten Helium-Tank wieder zugeführt werden. Mit Hilfe des im zweiten Helium-Tank angeordneten Refrigerators wird das expandierte Helium wieder verflüssigt und auf die Temperatur des im zweiten Helium-Tank befindlichen Heliums gebracht. Der Heliumverbrauch wird durch das erfindungsgemäße System stark minimiert, so dass ein kontinuierlicher Messbetrieb realisiert werden kann.

Die Erfindung realisiert ein verdampfungsfreies oder zumindest ein verdampfungsarmes supraleitendes Magnetsystem, wobei eine Rückführung des dem Magnetsystem zu Kühlzwecken entnommenen Heliums in den zweiten Tank innerhalb eines geschlossenen Systems erfolgt. Es findet daher kein unnötiger Verbrauch von Helium statt. Dadurch wird für den Betrieb des Magnetsystems weniger, im optimalen Fall gar kein Helium, zusätzlich zum bereits im Tank befindlichen Helium, benötigt. Das erfindungsgemäße System erlaubt daher einen kontinuierlichen Messbetrieb und erspart die Organisation der Heliumbeschaffung sowie des Nachfüllens. Darüber hinaus kann durch den verringerten Heliumverbrauch der zweite Helium-Tank im Vergleich zu bekannten Magnetsystemen kleiner dimensioniert werden, was eine Reduzierung der Größe der Gesamtapparatur ermöglicht.

Die Vorteile des erfindungsgemäßen Kryostaten kommen besonders gut zur Geltung, wenn der Kryostat im ersten Helium-Tank ein supraleitendes Magnetsystem, insbesondere einer Apparatur der magnetischen Resonanz enthält.

Bei einer vorteilhaften Ausführungsform ist der Refrigerator als Pulsrohrkühler ausgebildet. Durch die Verwendung eines Pulsrohr-Kühlers im zweiten Helium-Tank werden Störungen des Hauptmagnetfelds gering gehalten.

In einer bevorzugten Ausführungsform des Kryostaten ist der Refrigerator mehrstufig, vorzugsweise zweistufig ausgeführt. Mit Hilfe von mehrstufigen Refrigeratoren kann das Helium im zweiten Tank auf seine Siedetemperatur von 4,2K heruntergekühlt und somit verflüssigt werden.

In einer besonders bevorzugten Ausführungsform der Erfindung ist eine Stufe des Refrigerators vor dem kalten Ende mit einem im Kryostaten angeordneten Strahlungsschild thermisch leitend verbunden. Der Strahlungsschild kann somit mit der mit ihm verbundenen Stufe des Refrigerators gekühlt werden.

Besonders vorteilhaft ist es, wenn der mit der Stufe des Refrigerators verbundene Strahlungsschild die Helium-Tanks umgibt und wenn der die Kühlleistung des Refrigerators ausreicht, einen Tank mit flüssigem Stickstoff zu ersetzen. In diesem Fall entfällt die Bestückung der Anordnung mit flüssigem Stickstoff. Zudem kann durch den Verzicht auf einen Stickstofftank die Bauweise der Anordnung kompakter gestaltet werden.

Vorzugsweise enthält der Refrigerator in der Tieftemperaturstufe als Regenerator-material eine Substanz mit einem Phasenübergang bei tiefer Temperatur im Bereich um 4 K oder darunter, insbesondere einem magnetischen Phasenübergang. Der Phasenübergang bewirkt eine Steigerung der spezifischen Wärme des Regeneratormaterials, so dass auch bei sehr kleinen Temperaturen (T < 4K) eine Wärmeabgabe des Arbeitsgases an das Regeneratormaterial möglich ist.

Besonders bei Regeneratormaterialien mit einem magnetischen Phasenübergang ist es vorteilhaft, wenn das Regeneratormaterial im Kryostaten magnetisch abgeschirmt ist. Somit kann eine Störung des Hauptfelds durch den magnetischen Phasenübergang vermieden werden.

Eine weitere Ausführungsform der Erfindung sieht vor, dass der Refrigerator als Regenerator-Material eine Substanz mit einem Phasenübergang enthält, wobei der Phasenübergang nicht magnetisch ist. Derartige Regeneratormaterialien wirken im Zusammenhang mit magnetischen Anwendungen nicht störend

In einer speziellen Ausführungsform enthält der Refrigerator in der Tieftemperaturstufe zusätzlich oder ausschließlich stationäres Helium als Regeneratormaterial. Helium weist keinen magnetischen Phasenübergang auf und ist im Gegensatz zu sonst üblichen Regeneratormaterialien vergleichsweise günstig. Die Verwendung von Helium unter hohem Druck als Regeneratormaterial ist aus der DE 199 24 184 A1 bereits bekannt.

In einer besonders bevorzugten Ausführungsform der Erfindung ist der den Regenerator enthaltene Abschnitt des Refrigerators an einer Stelle im Kryostaten angeordnet, an der im Betrieb ein minimales Magnetfeld herrscht, z.B. im radialen Zwischenraum zwischen einer Haupt- und einer Abschirmspule der Magnetanordnung oder auch nur radial außerhalb der Magnetspule etwa im Bereich ihrer Mittelebene. Eine Wechselwirkung des Regeneratormaterials mit dem Hauptmagnetfeld wird dadurch minimiert.

Vorzugsweise sind der Kryostat und der Refrigerator so ausgelegt und dimensioniert, dass im Betrieb kein Helium in den Kryostaten nachgefüllt werden muss. Dies erhöht die Benutzerfreundlichkeit des Kryostaten und ermöglicht einen kontinuierlichen Betrieb der Magnetanordnung über sehr lange Zeiträume.

In einer bevorzugten Ausführungsform ist der zweite Helium-Tank oberhalb des ersten Helium-Tanks angeordnet. Der zweite Helium-Tank hat dabei eine hydrostatische Funktion inne, um den ersten Helium-Tank auf Atmosphärendruck zu halten.

In einer besonders bevorzugten Ausführungsform der Erfindung umfasst der geschlossene Heliumkreislauf eine Rückleitung zur Rückführung des geförderten Heliums, in der, vorzugsweise außerhalb des Kryostaten, ein Druckausgleichsbehälter angeordnet ist. Mit Hilfe des Druckausgleichsbehälters können Betriebsschwankungen im System ausgeglichen werden, beispielsweise falls aus dem ersten Helium-Tank mehr Helium abgepumpt wird als vom Refrigerator momentan verflüssigt werden kann oder umgekehrt. Der Druckausgleichsbehälter hat dabei die Funktion eines Puffers.

Eine weitere vorteilhafte Ausführungsform der Erfindung sieht im zweiten Helium-Tank eine Heizvorrichtung zur Erwärmung des Heliums vor. Dies ist insbesondere vorteilhaft für den Fall, dass der Refrigerator mehr Helium verflüssigt als über die Unterkühleinheit aus dem System abgepumpt wird. Durch die Heizvorrichtung kann die Menge des verflüssigten Heliums reguliert und somit ein stabiler Betriebszustand realisiert werden. Gleichzeitig ermöglicht die geregelte Heizvorrichtung die Konstanthaltung der Drucks in der zweiten Kammer und damit auch des Drucks in der ersten Kammer.

Des Weiteren ist es vorteilhaft, wenn am Kryostaten eine Einrichtung zum Einfüllen von Helium vorgesehen ist, die zumindest mit einem Helium-Tank verbunden ist. Vorzugsweise erfolgt die Verbindung mit dem zweiten Helium-Tank. Somit kann, falls beispielsweise über ein Überdruckventil Helium aus dem Kreislauf entwichen ist, ein Nachfüllen von Helium erfolgen.

Eine besonders vorteilhafte Ausführungsform des erfindungsgemäßen Kryostaten ergibt sich, wenn der zweite Helium-Tank flüssiges Helium mit einer Temperatur von ungefähr 4,2K enthält, wobei die beiden Helium-Tanks derart verbunden sind, dass sich das Helium in beiden Helium-Tanks auf einem gegenüber Atmosphärendruck p₀ leicht erhöhtem Druckniveau p₁ befindet. Durch den leichten Überdruck im Helium-Tank wird vermieden, dass Luft aus der Umgebung in den Helium-Tank gelangt. Die Differenz der beiden Druckniveaus p₁ und p₀ beträgt dabei weniger als 100 mbar, vorzugsweise ungefähr 50 mbar.

Eine Weiterbildung dieser Ausführungsform sieht Mittel vor, die bewirken, dass bei Ausfall des Refrigerators am zweiten Helium-Tank ein Überdruckventil zur Umgebung öffnet, derart, dass aus dem zweiten Helium-Tank abdampfendes Helium entlang des Refrigerators geführt wird und dabei Enthalpie an den Refrigerator abgibt, um dadurch den Wärmeeintrag in den zweiten Helium-Tank zu minimieren. Das durch den Ausfall des Refrigerators verdampfte Helium kann aus dem Helium-Tank entweichen und trägt dabei zusätzlich zur Kühlung des Refrigerators, sowie der Wand des Aufhängerohrs, in dem der Refrigerator angeordnet ist, bei, was den Wärmeeintrag in den zweiten Tank reduziert. Auf diese Weise kann die im Kryostaten befindliche Magnetanordnung im Störfall ohne zusätzlichen Aufwand wesentlich länger weiter betrieben werden als es ohne die Ausnutzung der Enthalpie des verdampfenden Heliums zur Kühlung des im Allgemeinen in einem Turm des Kryostaten angeordneten Refrigerators und der umgebenden Wände möglich ist. Im Normalbetrieb strömt nämlich durch diesen Turm kein Helium ab und die Kühlung erfolgt allein durch den Refrigerator, der dies im oben genannten Störfall nicht mehr leisten kann. Das aus dem ersten Tank abgepumpte, geförderte Helium kühlt weiterhin die anderen Türme des Kryostaten.

Bei einer besonders bevorzugten Weiterbildung des erfindungsgemäßen Kryostaten ist eine Leitung des geförderten Heliums mit dem Überdruckventil derart verbunden, dass bei Öffnung des Überdruckventils auch das geförderte Helium direkt an die Umgebung abgegeben wird. Bei Ausfall des Refrigerators kann durch diesen das geförderte Helium nicht mehr verflüssigt werden und würde sonst mit erhöhter Temperatur in den Helium-Tank gelangen und einen unerwünschten zusätzlichen Wärmeeintrag hervorrufen.

Bevorzugt ist der Kryostat Teil einer Apparatur der magnetischen Resonanz wie eines NMR-Spektrometers, eines Kernspintomographen oder eines ICR-Massenspektrometers. Diese Apparaturen sind besonders auf ein homogenes, stabiles und ungestörtes Magnetfeld in einem Untersuchungsvolumen angewiesen, so dass sie in erheblichem Maße von den Vorteilen des erfindungsgemäßen Magnetsystems profitieren.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Es zeigen:

- **Fig. 1**: eine schematische Darstellung eines erfindungsgemäßen Kryostaten mit eingebautem Refrigerator;
- **Fig. 2**: eine detaillierte schematische Darstellung des in dem erfindungsgemäßen Kryostaten eingebauten Refrigerators; und
- **Fig. 3**: eine schematische Darstellung eines erfindungsgemäßen Kryostaten mit Überdruckventil am zweiten Helium-Tank.

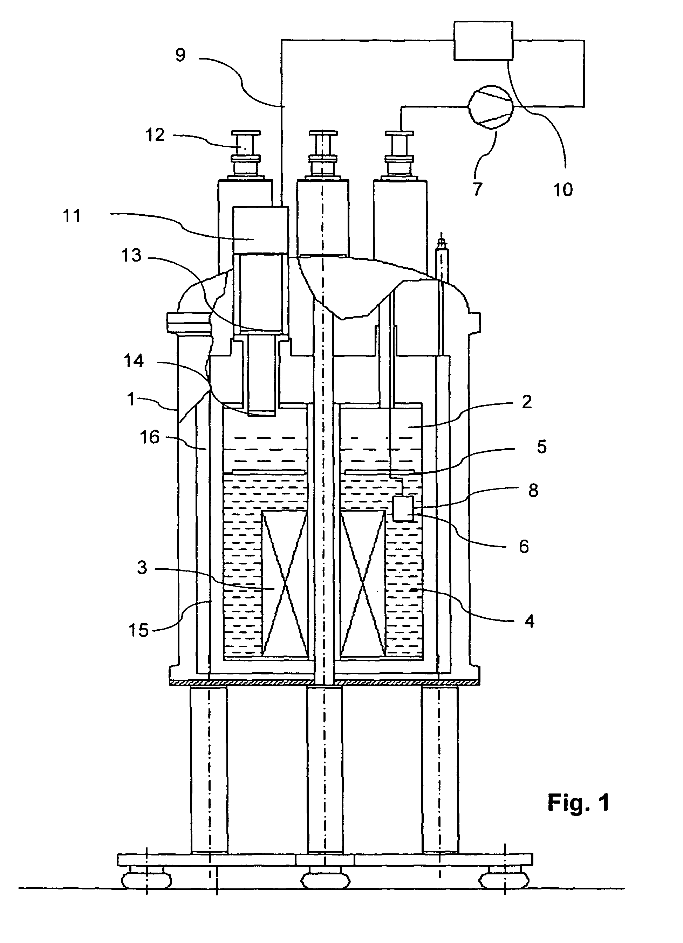

**Fig. 1** zeigt einen erfindungsgemäßen Kryostaten 1 mit einem im Kryostaten **1** angeordneten ersten Helium-Tank **4,** in dem sich eine Magnetspule **3** zur Erzeugung eines hochhomogenen Magnetfelds befindet. Oberhalb des ersten Helium-Tanks 4 ist ein zweiter Helium-Tank **2** angeordnet, der durch eine thermische Barriere 5 vom ersten Helium-Tank **4** getrennt ist. Im zweiten Helium-Tank 2 befindet sich flüssiges Helium unter Atmosphärendruck p₀ oder auf einem gegenüber dem Atmosphärendruck p₀ leicht erhöhtem Druckniveau p₁ auf einer Temperatur von über 3K, vorzugsweise 4,2K. Die beiden Helium-Tanks 2, 4 kommunizieren miteinander, so dass Helium vom oberen, zweiten Helium-Tank 2 in den unteren ersten Helium-Tank 4 strömen kann, wo das Helium mit Hilfe einer Kühleinrichtung **6** auf eine Temperatur deutlich unter 3K, vorzugsweise auf 1,8K, abgekühlt (unterkühlt) wird. Dazu wird Helium über die Kühleinrichtung 6 durch eine Pumpe **7** abgepumpt und mittels eines Joule-Thomson-Ventils expandiert. Ein Wärmetauscher, der in Form der Oberfläche **8** der Kühleinrichtung 6 ausgebildet sein kann, bewirkt eine Unterkühlung des Heliums im ersten Helium-Tank 4. Das über die Kühleinrichtung 6 abgepumpte und expandierte Helium wird über eine Rückleitung **9** in einen Druckausgleichsbehälter 10 geführt, von dem aus das Helium in den zweiten Helium-Tank 2 geleitet wird. Die Rückführung des expandierten Heliums erfolgt dabei entlang eines Refrigerators 11, der das expandierte Helium auf 4,2K abkühlt und wieder verflüssigt. Das über die Kühleinrichtung 6 entnommene Helium wird daher über einen geschlossenen Kreislauf dem zweiten Helium-Tank 2 wieder zugeführt, so dass ein Nachfüllen des zweiten Helium-Tanks 2 im Normalbetrieb nicht notwendig ist. Das in Fig. 1 im Kryostaten angeordnete Magnetsystem ist Teil eines hochauflösenden NMR-Spektrometers mit hoher Magnetfeldstärke im Bereich um oder über 18 Tesla.

Mit dem erfindungsgemäßen Kryostaten ist ein verbesserter Messbetrieb möglich, da die Anzahl der Heliumnachfüllvorgänge erheblich reduziert werden kann. Der zweite Helium-Tank 2, der bei bekannten Magnetsystemen einen relativ großen Vorrat an Helium beinhaltet, kann bei dem erfindungsgemäßen Magnetsystem daher wesentlich kleiner ausgestaltet werden. Der zweite Helium-Tank 2 erfüllt hier hauptsächlich eine hydrostatische Funktion, nämlich die Beibehaltung des Atmosphärendrucks beziehungsweise des erhöhten Druckniveaus im ersten Helium-Tank 4.

Der Druckausgleichsbehälter 10 dient zum Ausgleich von Druckschwankungen innerhalb der Rückleitung 9. Wird beispielsweise mehr Helium von der Pumpe 7 durch die Kühleinrichtung 6 abgepumpt als durch den Refrigerator 11 in den zweiten Helium-Tank 2 verflüssigt, so wird das überschüssige Helium im Druckausgleichsbehälter 10 gespeichert. Für den umgekehrten Fall, nämlich dass der Refrigerator 11 mehr Helium verflüssigt als aus dem ersten Helium-Tank 4 abgepumpt wird, ist bei dem Magnetsystem vorteilhafterweise eine Heizvorrichtung vorgesehen, mit deren Hilfe die Verflüssigungsmenge des Refrigerators 11 geregelt werden kann. Das erfindungsgemäße System soll dabei so eingestellt sein, dass der Refrigerator 11 bei abgeschalteter Heizvorrichtung mehr Helium verflüssigt als durch die Pumpe 7 durch die Kühleinrichtung 6 gefördert wird. Somit kann mittels der Heizvorrichtung auf einfache Weise ein Gleichgewicht innerhalb der Rückleitung 9 erzeugt werden. Prinzipiell ist es jedoch auch denkbar, die Regelung des Gleichgewichts innerhalb der Rückleitung 9 über die Leistung der Pumpe 7 oder durch Änderung der Betriebsfrequenz des Pulsrohrkühlers bzw. seiner kalten Stufe zu realisieren.

Der Refrigerator 11 aus Fig. 1 ist zweistufig ausgebildet, um das Helium auf seine Siedetemperatur abzukühlen. Die erste Stufe **13** des Refrigerators 11 kann dabei mit einem im Kryostaten 1 angeordneten Strahlungsschild **15** thermisch leitend verbunden sein. Der Strahlungsschild 15 dient zur Reduktion einfallender Strahlungsenergie und ist üblicherweise zumindest teilweise als Stickstofftank **16** ausgeführt, der den Strahlungsschild 15 auf etwa 40K hält. Durch eine thermische Verbindung des Strahlungsschilds 15 zum Refrigerator 11 kann die Kühlung des Strahlungsschilds 15 über den Refrigerator 11 erfolgen, so dass auf einen Stickstofftank 16 verzichtet werden kann. Hierdurch und durch die Reduzierung der Größe des zweiten Helium-Tanks 2 kann im Vergleich zu bekannten Kryostaten ein kompakterer Aufbau des erfindungsgemäßen Kryostaten realisiert werden. Das kalte Ende der zweiten Stufe **14** des Pulksrohr-Kühlers 11 ragt in den zweiten Helium-Tank 2 hinein, um das im zweiten Tank befindliche Helium zu kühlen und das rückgeführte Helium auf seine Siedetemperatur zu bringen und zu verflüssigen.

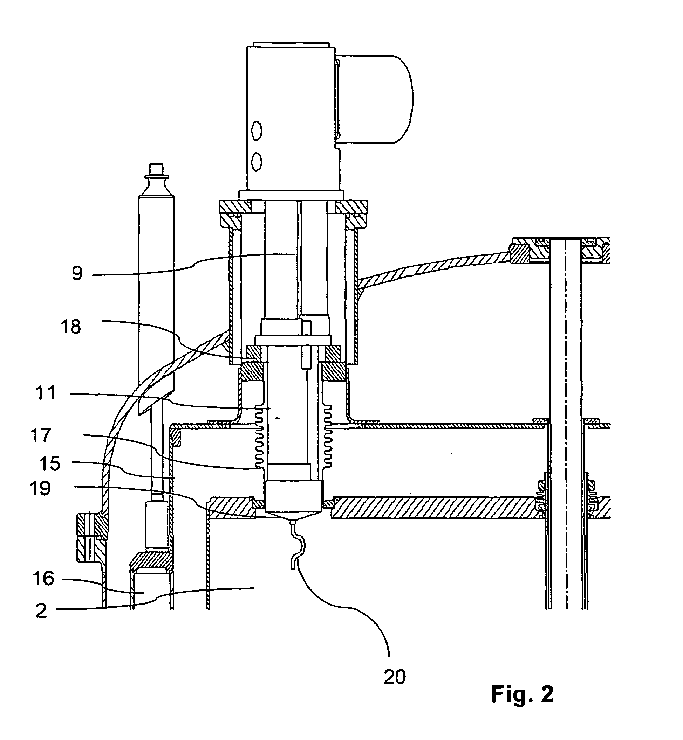

Eine detaillierte Darstellung des in das Magnetsystem eingebauten Refrigerators 11 ist in **Fig. 2** dargestellt. **Vom** zweiten Helium-Tank 2 ragt eine Abtrennung zum Vakuum **17** durch den Strahlungsschild 15. Der Refrigerator 11 befindet sich innerhalb der Abtrennung zum Vakuum 17 und ist mittels einer Flanschverbindung **18** an dieser thermisch leitend befestigt. Das über die Kühleinrichtung 6 abgepumpte Helium wird über die Rückleitung 9 entlang dem Refrigerator 11 (nicht sichtbar) in das kalte Ende **19** des Refrigerators 11 geführt, wo es sich verflüssigt und durch den Auslass **20** in den zweiten Helium-Tank 2 zurückgeführt wird.

Zur Erzeugung der für die Verflüssigung des Heliums benötigten tiefen Temperaturen umfasst der Refrigerator 11 ein Regeneratormaterial mit einem Phasenübergang. Der Phasenübergang bewirkt eine Steigerung der volumetrischen spezifischen Wärme des Regeneratormaterials und ermöglicht eine Abkühlung des Heliums auf unter 3K. Als geeignete Regeneratormaterialien sind Pb und seltene Erdverbindungen, wie zum Beispiel HoCo, Er₃Ni, ErNi, GdAlO₃ und ErNi_{0,9}Co_{0,1} bekannt. Diese Materialien weisen jedoch einen magnetischen Phasenübergang auf, der im Zusammenhang mit magnetischen Applikationen störend sein kann. Das erfindungsgemäße Magnetsystem sieht daher vor, das Regeneratormaterial im Kryostaten 1 magnetisch abzuschirmen. Dies kann beispielsweise mittels einer den Refrigerator 11 oder nur das Regeneratorgehäuse umgebenden hochpermeablen Folie oder mittels eines elektrisch hochleitfähigen Gehäuses erfolgen, das die schwankende Magnetisierung eliminiert. Es ist auch denkbar, ein supraleitendes Gehäuse um den Refrigerator 11 vorzusehen. Wie aus Fig. 1 ersichtlich, ist der Refrigerator 11 relativ weit von der Magnetspule 3 entfernt angeordnet, so dass bereits dadurch der Einfluss der oben genannten aus dem magnetischen Phasenübergang des Regeneratormaterials resultierenden Störeffekte minimiert wird.

Aus sicherheitstechnischen Gründen kann der erfindungsgemäße Kryostat 1 mit einem Überdruckventil ausgestattet sein, durch das bei Erhitzung des Heliums, beispielsweise durch einen Quench der Magnetspule 3 oder bei einem Ausfall des Refrigerators 11, Helium in die Atmosphäre entweichen kann, um eine ungewollte Erhöhung des Drucks innerhalb der Helium-Tanks zu vermeiden. In diesem Fall kann ein Nachfüllen von Helium in den zweiten Helium-Tank 2 notwendig sein, was über eine Einfülleinrichtung **1**2 erfolgen kann. Bei konventionellen Kryostaten ist das Überdruckventil aus platztechnischen Gründen in Hals- oder Aufhängerohren angeordnet, in denen kein Refrigerator eingebaut ist, so dass das überschüssige verdampfte Helium durch Spalte in den Hals- oder Aufhängerohren in die Atmosphäre gelangt.

Bei einem Ausfall des Refrigerators 11 wird das durch die Leitung 9 geförderte Helium nicht mehr verflüssigt, so dass sowohl über das geförderte Helium als auch über den Refrigerator 11 selbst ein Wärmeeintrag in den zweiten Helium-Tank 2 erfolgt. Der Heliumverbrauch steigt dann sprunghaft an (bis zu 100l an einem Wochenende), was zur Folge hat, dass die zu kühlende Magnetanordnung nicht mehr ausreichend gekühlt werden kann und somit der Betrieb unterbrochen werden muss oder aber ein sehr großer Helium-Tank notwendig ist, um einen Ausfall der Gesamtapparatur zu verhindern.

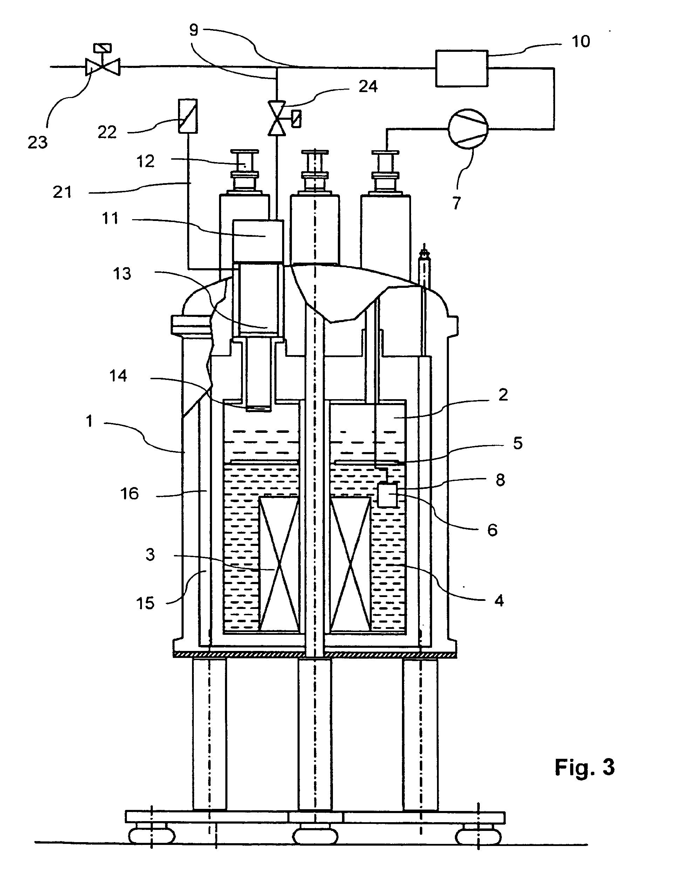

**Fig.3** zeigt eine vorteilhafte Weiterbildung des in Fig. 1 dargestellten Kryostaten 1, bei dem ein Überdruckventil **22** bei einem Ausfall des Refrigerators 11 derart zur Umgebung öffnet, dass aus dem zweiten Helium-Tank 2 abdampfendes Helium entlang des Refrigerators 11 geführt wird. Das abdampfende Helium wird über eine Leitung **21** in die Atmosphäre abgegeben. Durch das Vorbeiströmen des Heliumdampfes am Refrigerator 11 erfolgt ein Übergang von Enthalpie vom Heliumdampf an den Refrigerator 11, an die Aufhängung sowie an die Wand des Aufhängerohrs und bewirkt somit eine Kühlung dieser Strukturen. Ein Wärmeeintrag über den (nicht aktiven) Refrigerator 11 wird somit zumindest stark verringert, so dass der Kryostat 1 sich in einem Zustand befindet, der dem Zustand eines Kryostaten ganz ohne den Refrigerator 11 nahe kommt. Um einen zusätzlichen Wärmeeintrag in den zweiten Helium-Tank 2 über das aus dem ersten Helium-Tank 4 in der Leitung 9 geförderte (warme) Helium zu vermeiden, ist bei der in Fig. 3 gezeigten Ausführungsform die Leitung 9 zusätzlich mit einem weiteren Ventil **23** und einem Ventil **24** derart ausgestattet , dass bei Öffnung des Überdruckventils 22 auch das durch die Leitung 9 geförderte Helium durch ein Ventil 23 direkt an die Umgebung abgegeben wird. Das Ventil 23 ist als Rückschlagventil ausgebildet, damit keine Umgebungsluft in den Kryostaten gelangen kann und öffnet bei Ausfall des Refrigerators 11 oder bei Öffnung des Überdruckventils 22. Gleichzeitig oder zeitlich verzögert schließt das Ventil 24, um einen Rückstrom des durch die Pumpe geförderten Heliums in den zweiten Helium-Tank 2 zu verhindern. Der Kryostat 1 kann somit auf zwei Betriebsarten betrieben werden, nämlich in einem Normalbetrieb und einem Störbetrieb. Bei einem Ausfall des Refrigerators 11 wird durch die Ventile 23 und 24, welche vorzugsweise als Magnetventile ausgebildet sind, vom Normalbetrieb auf Störbetrieb umgeschaltet. Diese Ausführungsform gestattet es, auch im Störfall den Kryostaten noch eine relativ lange Zeit zu betreiben, da der Heliumverbrauch nicht dadurch übermäßig erhöht ist, dass sich die Strukturen im Bereich (Turm) des Refrigerators 11 ungekühlt aufwärmen und es auf diesem Weg zu einem extremen Eintrag von Wärme in den zweiten Helium-Tank 2 kommt. Der erfindungsgemäße Kryostat 1 verringert auf die oben beschriebene Weise diesen Wärmeeintrag in den zweiten Helium-Tank 2 entscheidend und ermöglicht somit eine kompaktere Ausführung des Kryostaten 1, die auch bei Ausfall des Refrigerators 11 längere Zeit noch weiter betrieben werden kann.

Insgesamt ergibt sich ein kompaktes Magnetsystem, das einen kontinuierlichen Messbetrieb erlaubt und dem Personal die Beschaffung und ein unkomfortables Nachfüllen des Heliums weitgehend erspart.

### Bezugszeichenliste

- 1: Kryostat
- 2: zweiter Helium-Tank
- 3: Magnetspule
- 4: erster Helium-Tank
- 5: thermische Barriere
- 6: Kühleinrichtung
- 7: Pumpe
- 8: Oberfläche der Kühleinrichtung
- 9: Rückleitung
- 10: Druckausgleichsbehälter
- 11: Refrigerator
- 12: Einfülleinrichtung (Turm)
- 13: 1. Stufe des Pulsrohrkühlers
- 14: 2. Stufe des Pulsrohrkühlers
- 15: Strahlungsschild
- 16: Stickstofftank
- 17: Abtrennung zum Vakuum
- 18: Flanschverbindung
- 19: kaltes Ende des Pulsrohrkühlers
- 20: Auslass verflüssigtes Helium
- 21: Leitung
- 22: Überdruckventil
- 23: Überdruck- und Rückschlagventil
- 24: Ventil

## Patentansprüche

1. Kryostat (1) mit einem ersten Helium-Tank (4), der Helium mit einer Betriebstemperatur T₁ < 3K enthält und einen zweiten Helium-Tank (2), der mit dem ersten Helium-Tank (4) in Verbindung steht und flüssiges Helium bei einer Betriebstemperatur T₂ > 3K enthält, wobei im ersten Helium-Tank (4) eine Kühleinrichtung (6) vorgesehen ist, die im ersten Helium-Tank (4) eine Betriebstemperatur T₁ < 3K erzeugt, und wobei die Kühleinrichtung (6) als Joule-Thomson-Ventil mit nachgeschaltetem Wärmetauscher ausgeführt ist, aus welchem abgepumptes Hellum in einen Raumtemperatur-Bereich außerhalb des Kryostaten (1) gefördert wird
**dadurch gekennzeichnet,**
**dass** ein Refrigerator (11) vorgesehen ist, dessen kaltes Ende (19) in den zweiten Helium-Tank (2) ragt, und dass im Normalbetrieb das geförderte Hellum in einem geschlossenen Kreislauf entlang dem Refrigerator (11) in den zweiten Helium-Tank (2) zurück geführt, **dadurch** vorgekühlt und am kalten Ende (19) des Refrigerators (11 ) verflüssigt wird.

2. Kryostat (1) nach Anspruch 1, **dadurch gekennzeichnet, dass** der Kryostat (1) im ersten Helium-Tank (4) ein supraleitendes Magnetsystem, insbesondere eine Apparatur der magnetischen Resonanz enthält.

3. Kryostat (1) nach einem der vorhergehenden Ansprüche, **dadurch gekennzeichnet, dass** der Refrigerator (11) als Pulsrohrkühler ausgebildet ist.

4. Kryostat (1) nach einem der vorhergehenden Ansprüche, **dadurch gekennzeichnet, dass** der Refrigerator (11) mehrstufig, vorzugsweise zweistufig ausgeführt ist.

5. Kryostat (1) nach Anspruch 4, **dadurch gekennzeichnet, dass** eine Stufe des Refrigerators (11) vor dem kalten Ende (19) mit einem im Kryostaten (1) angeordneten Strahlungsschild (15) thermisch leitend verbunden ist.

6. Kryostat (1) nach Anspruch 5, **dadurch gekennzeichnet, dass** der mit der 1. Stufe des Refrigerators (11) verbundene Strahlungsschild (15) die Helium-Tanks (2, 4) umgibt, und dass die Kühlleistung des Refrigerators (11) ausreicht, einen Tank (16) mit flüssigem Stickstoff zu ersetzen.

7. Kryostat (1) nach einem der vorhergehenden Ansprüche, **dadurch gekennzeichnet, dass** der Refrigerator (11) als Regenerator-Material eine Substanz mit einem Phasenübergang, insbesondere einem magnetischen Phasenübergang enthält.

8. Kryostat (1) nach Anspruch 7, **dadurch gekennzeichnet, dass** das Regenerator-Material im Kryostaten (1) magnetisch abgeschirmt ist.

9. Kryostat (1) nach einem der vorhergehenden Ansprüche, **dadurch gekennzeichnet, dass** der Refrigerator (11) als Regenerator-Material eine Substanz mit einem Phasenübergang enthält, wobei der Phasenübergang nicht magnetisch ist.

10. Kryostat (1) nach einem der vorhergehenden Ansprüche, **dadurch gekennzeichnet, dass** der Refrigerator (11) Helium als Regenerator-Material enthält.

11. Kryostat (1) nach einem der vorhergehenden Ansprüche, **dadurch gekennzeichnet, dass** der den Regenerator enthaltende Abschnitt des Refrigerators (11) an einer Stelle im Kryostaten (1) angeordnet ist, an der im Betrieb ein minimales Magnetfeld herrscht.

12. Kryostat (1) nach einem der vorhergehenden Ansprüche, **dadurch gekennzeichnet, dass** der Kryostat (1) und der Refrigerator (11) so ausgelegt und dimensioniert sind, dass im Betrieb kein Helium in den Kryostaten (1) nachgefüllt werden muss.

13. Kryostat (1) nach einem der vorhergehenden Ansprüche, **dadurch gekennzeichnet, dass** der zweite Helium-Tank (2) oberhalb des ersten Helium-Tanks (4) angeordnet ist.

14. Kryostat (1) nach einem der vorhergehenden Ansprüche, **dadurch gekennzeichnet, dass** der geschlossene Heliumkreislauf eine Rückleitung (9) zur Rückführung des geförderten Heliums umfasst, in der, vorzugsweise außerhalb des Kryostaten(1), ein Druckausgleichsbehälter (10) angeordnet ist.

15. Kryostat (1) nach einem der vorhergehenden Ansprüche, **dadurch gekennzeichnet, dass** im zweiten Helium-Tank (2) eine Heizvorrichtung zur Erwärmung des Heliums vorgesehen ist.

16. Kryostat (1) nach einem der vorhergehenden Ansprüche, **dadurch gekennzeichnet, dass** am Kryostaten (1) eine Einrichtung (12) zum Einfüllen von Helium vorgesehen ist, die zumindest mit einem der Helium-Tanks (2, 4) verbunden ist.

17. Kryostat (1) nach einem der vorhergehenden Ansprüche, **dadurch gekennzeichnet, dass** der zweite Helium-Tank (2) flüssiges Helium mit einer Temperatur von ungefähr 4,2K enthält, wobei die beiden Helium-Tanks (2, 4) derart verbunden sind, dass sich das Helium in beiden Helium-Tanks (2, 4) auf einem gegenüber Atmosphärendruck p₀ leicht erhöhtem Druckniveau p₁ befindet.

18. Kryostat (1) nach Anspruch 16, **dadurch gekennzeichnet, dass** Mittel vorgesehen sind, die bewirken, dass bei Ausfall des Refrigerators (11) am zweiten Helium-Tank (2) ein Überdruckventil (22) zur Umgebung öffnet, derart, dass aus dem zweiten Helium-Tank (2) abdampfendes Helium entlang des Refrigerators (11) geführt wird und dabei Enthalpie an den Refrigerator (11) abgibt, um **dadurch** den Wärmeeintrag in den zweiten Helium-Tank (2) zu minimieren.

## Claims

1. Cryostat (1) with a first helium tank (4) which contains helium at an operating temperature T₁<3K, and a second helium tank (2) which is connected to the first helium tank (4) and contains liquid helium at an operating temperature T₂>3K, wherein a cooling means (6) is provided in the first helium tank (4), which generates an operating temperature T₁<3K in the first helium tank (4), and wherein the cooling means (6) is designed as Joule-Thomson valve with downstream heat exchanger from which pumped helium is supplied to a room temperature region outside of the cryostat (1), **characterized in that** a refrigerator (11) is provided whose cold end (19) projects into the second helium tank (2) and the supplied helium is returned during normal operation in a closed loop past the refrigerator (11) and into the second helium tank (2), thereby being pre-cooled and liquefied at the cold end (19) of the refrigerator (11).

2. Cryostat (1) according to claim 1, **characterized in that** the first helium tank (4) of the cryostat (1) contains a superconducting magnet system, in particular, a magnetic resonance apparatus.

3. Cryostat (1) according to any one of the preceding claims, **characterized in that** the refrigerator (11) is designed as pulse tube cooler.

4. Cryostat (1) according to any one of the preceding claims, **characterized in that** the refrigerator (11) is designed to have several stages, preferably two stages.

5. Cryostat (1) according to claim 4, **characterized in that** a stage of the refrigerator (11) upstream of the cold end (19) is thermally conducingly connected to a radiation shield (15) which is disposed in the cryostat (1).

6. Cryostat (1) according to claim 5, **characterized in that** the radiation shield (15) which is connected to the first stage of the refrigerator (11) surrounds the helium tanks (2, 4) and the cooling power of the refrigerator (11) is sufficient to replace a tank (16) of liquid nitrogen.

7. Cryostat (1) according to any one of the preceding claims, **characterized in that** the refrigerator (11) contains a regenerator material substance having a phase transition, in particular a magnetic phase transition.

8. Cryostat (1) according to claim 7, **characterized in that** the regenerator material is magnetically shielded in the cryostat (1).

9. Cryostat (1) according to any one of the preceding claims, **characterized in that** the refrigerator (11) contains a regenerator material substance with a non-magnetic phase transition.

10. Cryostat (1) according to any one of the preceding claims, **characterized in that** the refrigerator (11) contains helium as regenerator material.

11. Cryostat (1) according to any one of the preceding claims, **characterized in that** the section of the refrigerator (11) containing the regenerator is disposed at one location in the cryostat (1) which has a minimum magnetic field during operation.

12. Cryostat (1) according to any one of the preceding claims, **characterized in that** the cryostat (1) and the refrigerator (11) are designed and dimensioned such that no helium must be refilled into the cryostat (1) during operation.

13. Cryostat (1) according to any one of the preceding claims, **characterized in that** the second helium tank (2) is disposed above the first helium tank (4).

14. Cryostat (1) according to any one of the preceding claims, **characterized in that** the closed helium loop comprises a return line (9) to return the supplied helium, the line (9) comprising a pressure compensation container (10), preferably outside of the cryostat (1).

15. Cryostat (1) according to any one of the preceding claims, **characterized in that** a heating device is provided in the second helium tank (2) to heat the helium.

16. Cryostat (1) according to any one of the preceding claims, **characterized in that** a means (12) for filling-in helium is provided on the cryostat (1), which is connected to at least one of the helium tanks (2, 4).

17. Cryostat (1) according to any one of the preceding claims, **characterized in that** the second helium tank (2) contains liquid helium at a temperature of approximately 4.2 K, wherein the two helium tanks (2, 4) are connected such that the helium in both helium tanks (2, 4) is at a pressure level p₁ which is slightly higher than atmospheric pressure p₀.

18. Cryostat (1) according to claim 16, **characterized in that** if the refrigerator (11) fails, means are provided to open an overpressure valve (22) at the second helium tank (2) to the surroundings, such that helium evaporated from the second helium tank (2) is guided along the refrigerator (11) thereby discharging enthalpy to the refrigerator (11) to minimize the heat input into the second helium tank (2).

## Revendications

1. Cryostat (1) avec un premier réservoir d'hélium (4) qui contient de l'hélium à une température de service T₁ < 3 K et un deuxième réservoir d'hélium (2) qui est en communication avec le premier réservoir d'hélium (4) et qui contient de l'hélium liquide à une température de service T₂ > 3 K, un dispositif de réfrigération (6) étant prévu dans le premier réservoir d'hélium (4), qui produit dans le premier réservoir d'hélium (4) une température de service T₁ < 3 K, et le dispositif de réfrigération (6) étant réalisé sous la forme d'une vanne de Joule-Thomson avec échangeur thermique placé en aval, à partir de laquelle de l'hélium pompé est transporté dans une zone à température ambiante extérieure au cryostat (1),
**caractérisé en ce**
**qu'**un réfrigérateur (11) est prévu, dont l'extrémité froide (19) dépasse dans le deuxième réservoir d'hélium (2), et qu'en fonctionnement normal l'hélium transporté est ramené en circuit fermé le long du réfrigérateur (11) dans le deuxième réservoir d'hélium (2), moyennant quoi il est préréfrigéré et liquéfié à l'extrémité froide (19) du réfrigérateur (11).

2. Cryostat (1) selon la revendication 1, **caractérisé en ce que** le cryostat (1) contient dans le premier réservoir d'hélium (4) un système magnétique supraconducteur, en particulier un appareillage de résonance magnétique.

3. Cryostat (1) selon une des revendications précédentes, **caractérisé en ce que** le réfrigérateur (11) est réalisé sous la forme d'un réfrigérateur à tube pulsé.

4. Cryostat (1) selon une des revendications précédentes, **caractérisé en ce que** le réfrigérateur (11) est réalisé à plusieurs étages, de préférence à deux étages.

5. Cryostat (1) selon la revendication 4, **caractérisé en ce qu'**un étage du réfrigérateur (11) est relié avant l'extrémité froide (19) de manière thermoconductrice à un écran anti-rayonnement (15) disposé dans le cryostat (1).

6. Cryostat (1) selon la revendication 5, **caractérisé en ce que** l'écran anti-rayonnement (15) relié au 1^{er} étage du réfrigérateur (11) entoure les réservoirs d'hélium (2, 4), et que la puissance frigorifique du réfrigérateur (11) suffit pour remplacer un réservoir (16) contenant de l'azote liquide.

7. Cryostat (1) selon une des revendications précédentes, **caractérisé en ce que** le réfrigérateur (11) contient en tant que matériau régénérateur une substance présentant une transition de phase, en particulier une transition de phase magnétique.

8. Cryostat (1) selon la revendication 7, **caractérisé en ce que** le matériau régénérateur dans le cryostat (1) est blindé magnétiquement.

9. Cryostat (1) selon une des revendications précédentes, **caractérisé en ce que** le réfrigérateur (11) contient en tant que matériau régénérateur une substance présentant une transition de phase, la transition de phase n'étant pas magnétique.

10. Cryostat (1) selon une des revendications précédentes, **caractérisé en ce que** le réfrigérateur (11) contient de l'hélium en tant que matériau régénérateur.

11. Cryostat (1) selon une des revendications précédentes, **caractérisé en ce que** la partie du réfrigérateur (11) contenant le régénérateur est disposée à un emplacement du cryostat (1) où règne un champ magnétique minimal en fonctionnement.

12. Cryostat (1) selon une des revendications précédentes, **caractérisé en ce que** le cryostat (1) et le réfrigérateur (11) sont conçus et dimensionnés de façon qu'il ne soit pas nécessaire de rajouter de l'hélium dans le cryostat (1) en fonctionnement.

13. Cryostat (1) selon une des revendications précédentes, **caractérisé en ce que** le deuxième réservoir d'hélium (2) est disposé au-dessus du premier réservoir d'hélium (4).

14. Cryostat (1) selon une des revendications précédentes, **caractérisé en ce que** le circuit fermé d'hélium comprend une conduite de retour (9) pour le retour de l'hélium transporté, dans laquelle, de préférence à l'extérieur du cryostat (1), est disposé un réservoir de compensation de pression (10).

15. Cryostat (1) selon une des revendications précédentes, **caractérisé en ce qu'**un dispositif de chauffage servant à réchauffer l'hélium est prévu dans le deuxième réservoir d'hélium (2).

16. Cryostat (1) selon une des revendications précédentes, **caractérisé en ce qu'**un dispositif (12) servant au remplissage d'hélium, qui est en communication avec au moins un des réservoirs d'hélium (2, 4), est prévu sur le cryostat (1).

17. Cryostat (1) selon une des revendications précédentes, **caractérisé en ce que** le deuxième réservoir d'hélium (2) contient de l'hélium liquide à une température d'environ 4,2 K, les deux réservoirs d'hélium (2, 4) étant reliés de telle manière que l'hélium dans les deux réservoirs d'hélium (2, 4) se trouve à un niveau de pression p₁ légèrement supérieur à une pression atmosphérique p₀.

18. Cryostat (1) selon la revendication 16, **caractérisé en ce qu'**il est prévu des moyens qui ont pour effet qu'en cas de défaillance du réfrigérateur (11), une soupape de surpression (22) sur le deuxième réservoir d'hélium (2) s'ouvre vers l'environnement, de façon que de l'hélium s'évaporant du deuxième réservoir d'hélium (2) soit guidé le long du réfrigérateur (11) et cède ce faisant de l'enthalpie au réfrigérateur (11) pour minimiser par ce moyen l'apport de chaleur au deuxième réservoir d'hélium (2).
